# EUROPEAN PATENT SPECIFICATION

(11) **EP 3 477 267 B1**
(45) Date of publication and mention of the grant of the patent: **06.11.2024**
(21) Application number: 17815187.4
(22) Date of filing: 08.06.2017
(51) Int. Cl.: G01J 5/34, G08B 13/191, G01J 5/08, G01J 5/00, G01J 5/02, H10N 15/10, G01J 5/07

(54) **INFRARED DETECTION ELEMENT AND INFRARED DETECTION DEVICE**
INFRAROTDETEKTIONSELEMENT UND INFRAROTDETEKTIONSVORRICHTUNG
ÉLÉMENT DE DÉTECTION INFRAROUGE ET DISPOSITIF DE DÉTECTION INFRAROUGE

(30) Priority: 23.06.2016 JP 2016124260
(43) Date of publication of application: 01.05.2019
(73) Proprietor: Murata Manufacturing Co., Ltd., Kyoto 617-8555 (JP)
(72) Inventor: OTAKE, Tomonori, Nagaokakyo-shi Kyoto 617-8555 (JP)
(74) Representative: Reddie & Grose LLP
(86) International application number: PCT/JP2017/021251
(87) International publication number: WO 2017/221718

(56) References cited:
- WO-A1-2012/056943
- JP-A- 2012 177 680
- JP-A- 2013 195 148
- JP-A- 2013 524 177
- JP-A- H 053 346
- JP-A- H05 164 608
- JP-A- H05 164 608
- JP-A- H08 184 493
- JP-A- H1 062 243
- JP-A- H1 062 243
- JP-A- S62 276 422
- US-A- 4 800 278
- US-A1- 2013 144 563
- US-A1- 2015 369 668

## Description

### Technical Field

The present invention relates to a pyroelectric infrared detection element in which a light receiving electrode is formed on a pyroelectric body.

### Background Art

Japanese Unexamined Patent Application Publication No. 2000-292551 discloses a pyroelectric infrared detection element of dual twin type. The pyroelectric infrared detection element disclosed in JP2000-292551 includes two H-shaped light receiving electrodes. The two light receiving electrodes are connected to separate detection circuits in one-to-one relation. The two light receiving electrodes have different infrared detection-target regions. More specifically, a detection-target region of a first light receiving electrode is a region where infrared light from a small animal, such as a dog, or a moving heat-source body (such as a self-propelled cleaner) is not detected, and where infrared light from a human being can be detected. A detection-target region of a second light receiving electrode is a region where the infrared light mainly from the small animal or the moving heat-source body can be detected.

In the pyroelectric infrared detection element disclosed in JP2000-292551, detection of the human being and detection of the small animal are discriminated by separately using outputs of two detection circuits.

However, the pyroelectric infrared detection element disclosed in JP2000-292551 is required to include the detection circuit for each of the light receiving electrodes. Thus, the pyroelectric infrared detection has a complicated structure and a larger-sized shape.

Accordingly, we have appreciated that it is desirable to provide a pyroelectric infrared detection element having a small size and being able to reliably detect plural types of detection targets.

JP 2013195148 provides means to correct a decrease of an infrared radiation reception amount at a peripheral part of a sensor array region, in an infrared sensor device including the sensor array region having a plurality of pixels each having an infrared absorption film and a temperature sensor arranged in line or in matrix and a condensing lens arranged opposite to the sensor array region. To do this an infrared sensor device is provided which comprises: a sensor array region having a plurality of pixels each having an infrared absorption film and a temperature sensor arranged in line; and a condensing lens arranged opposite to the sensor array region. The infrared detection sensitivity of a pixel is changed to be higher from a centre part to a peripheral part of the sensor array region 1 according to an area change of the infrared absorption film.

US 2013/144563 provides a radiation sensor which comprises plural radiation sensing elements arranged along an arrangement line, a lens having an optical axis focusing radiation towards the sensing elements, and circuitry receiving the electric signal of the sensing elements and providing an output signal, in which the midpoint of the arrangement line is offset against the optical axis of the converging section. Some of the sensing elements may have different sizes and have different relative sensitivity compared to each other. Two or more pairs of adjacent sensing elements have a different pitch.

US 2015/369668 provides an infrared detection element which includes first and second pyroelectric elements arranged in a single pyroelectric substrate. First pyroelectric element includes a first surface electrode, a first back face electrode, and a first portion interposed between first surface and back face electrodes. First portion is provided as part of pyroelectric substrate. Second pyroelectric element includes a second surface electrode, a second back face electrode, and a second portion interposed between second surface and back face electrodes. Second portion is provided as part of pyroelectric substrate. Pyroelectric substrate is provided in part thereof surrounding first pyroelectric element with a slit shaped along an outer periphery of first pyroelectric element. Slit is formed out of regions in which a first surface wiring and a first back face wiring are disposed. Part of pyroelectric substrate surrounding second pyroelectric element is continuously formed over an entire circumference of second portion.

### SUMMARY OF INVENTION

The invention is defined in the independent claims to which reference should now be made. Advantageous features are set forth in the dependent claims.

An infrared detection device according to the present invention is disclosed in independent claim 1.

In the infrared detection element according to the present invention, preferably, the light-sensitivity adjustment member is an infrared absorption film arranged only on a surface of the first light receiving electrode.

With the above-described feature, the difference between the infrared detection sensitivity for the first region and the infrared detection sensitivity for the second region is increased.

The infrared detection element according to the present invention may be constituted as follows. The light-sensitivity adjustment member is a first infrared absorption film arranged on a surface of the first light receiving electrode, and a second infrared absorption film arranged on a surface of the second light receiving electrode. The first infrared absorption film has a higher infrared absorbance than the second infrared absorption film.

With the above-described features, the difference between the infrared detection sensitivity for the first region and the infrared detection sensitivity for the second region is adjusted depending on the difference in infrared absorbance.

In the infrared detection element according to the present invention, a coverage of the first infrared absorption film with respect to the first light receiving electrode may be higher than a coverage of the second infrared absorption film with respect to the second light receiving electrode.

With the above-described feature, the difference between the infrared detection sensitivity for the first region and the infrared detection sensitivity for the second region is adjusted depending on the coverage.

In the infrared detection element according to the present invention, the first light receiving electrode has a higher infrared absorbance than the second light receiving electrode.

With the above-described feature, the difference in infrared absorbance is obtained depending on electrode materials.

The infrared detection element according to the present invention may be constituted as follows. A polarizability of the pyroelectric body is different between a first region in which the first light receiving electrode is formed on the surface of the pyroelectric body and a second region in which the second light receiving electrode is formed on the surface of the pyroelectric body. The first region has a higher polarizability than the second region.

The infrared detection element according to the present invention may be constituted as follows. A thickness of the pyroelectric body is different between a first region in which the first light receiving electrode is formed and a second region in which the second light receiving electrode is formed. The pyroelectric body in the first region has a smaller thickness than that of the pyroelectric body in the second region.

With the above-described features, the difference in sensitivity for the infrared light between detection signals is obtained depending on the constitution of the pyroelectric body.

An infrared detection device according to the present invention includes a first element, a second element, a connection portion, an impedance conversion element, and a determination unit. The first element includes a first light receiving electrode and a pyroelectric body. The second element includes a second light receiving electrode and a pyroelectric body. The connection portion interconnects the first element and the second element. The impedance conversion element generates detection signals from electric charges in the first element and the second element through the connection portion. The determination unit determines detection of infrared light on the basis of the detection signals.

With the above-described features, detection of the infrared light from the first region and detection of the infrared light from the second region are realized with one impedance conversion element and one determination unit.

According to the present invention, the pyroelectric infrared detection element capable of reliably detecting plural types of detection targets can be realized in a small size.

### BRIEF DESCRIPTION OF DRAWINGS

Fig. 1(A) is a plan view of an infrared detection element according to a first embodiment of the present invention, and Fig. 1(B) is a sectional view taken along A-A in Fig. 1(A).
Fig. 2 is a circuit diagram of an infrared detection device according to the first embodiment of the present invention.
Fig. 3 illustrates an application example of the infrared detection device according to the present invention.
Fig. 4 is a plan view illustrating a constitution of an infrared detection element according to a second embodiment of the present invention.
Fig. 5 is a plan view illustrating a constitution of an infrared detection element according to a third embodiment of the present invention.
Fig. 6 is a side sectional view illustrating a constitution of an infrared detection element according to a fourth embodiment of the present invention.
Fig. 7 is a side sectional view illustrating a constitution of an infrared detection element according to a fifth embodiment of the present invention.
Fig. 8 is a side sectional view illustrating a constitution of an infrared detection element according to a sixth embodiment of the present invention.
Fig. 9 is a circuit diagram of an infrared detection device in another form according to an embodiment of the present invention.

### DESCRIPTION OF EMBODIMENTS

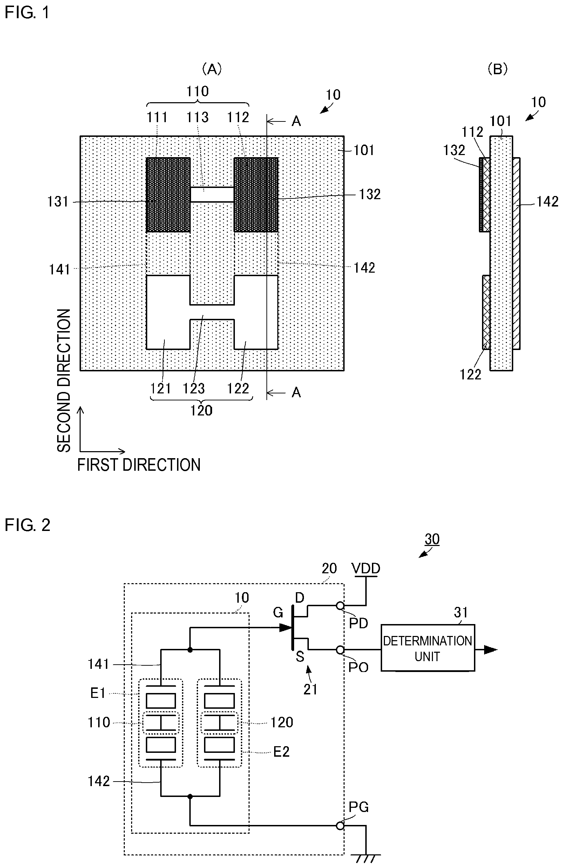

An infrared detection element and an infrared detection device according to a first embodiment of the present invention will be described below with reference to the drawings. Fig. 1(A) is a plan view of the infrared detection element according to the first embodiment of the present invention. Fig. 1(B) is a sectional view taken along A-A in Fig. 1(A).

As illustrated in Fig. 1, the infrared detection element 10 includes a pyroelectric body 101, a light receiving electrode 110, a light receiving electrode 120, a blackened film 131, a blackened film 132, and connection electrodes 141 and 142. The light receiving electrode 110 corresponds to a "first light receiving electrode" in the present invention, and the light receiving electrode 120 corresponds to a "second light receiving electrode" in the present invention. The blackened film 131 corresponds to a "first blackened film" in the present invention, and the blackened film 132 corresponds to a "second blackened film" in the present invention.

The pyroelectric body 101 is made of a material generating the pyroelectric effect. The pyroelectric body 101 is made of, for example, a ferroelectric material. The pyroelectric body 101 is in the form of a flat plate.

The light receiving electrode 110 and the light receiving electrode 120 are formed on a front surface of the pyroelectric body 101.

The light receiving electrode 110 includes detection electrodes 111 and 112, and a wiring electrode 113. The detection electrodes 111 and 112 are each rectangular when viewed in plan. The detection electrodes 111 and 112 are arranged in spaced relation along a first direction. The wiring electrode 113 is a linear electrode extending along the first direction. The wiring electrode 113 interconnects the detection electrode 111 and the detection electrode 112. A length of the wiring electrode 113 along a second direction is shorter than that of the detection electrode 111 along the second direction and that of the detection electrode 112 along the second direction. Thus, the light receiving electrode 110 is an H-shaped electrode when viewed in plan. The detection electrode 111 and the detection electrode 112 preferably have the same shape. With the detection electrode 111 and the detection electrode 112 having the same shape, infrared detection accuracy is improved because both the detection electrodes are balanced to each other and stabilized with respect to variations of outside air temperature.

The light receiving electrode 120 includes detection electrodes 121 and 122, and a wiring electrode 123. The detection electrodes 121 and 122 are each rectangular when viewed in plan. The detection electrodes 121 and 122 are arranged in spaced relation along the first direction. The wiring electrode 123 is a linear electrode extending along the first direction. The wiring electrode 123 interconnects the detection electrode 121 and the detection electrode 122. A length of the wiring electrode 123 along the second direction is shorter than that of the detection electrode 121 along the second direction and that of the detection electrode 122 along the second direction. Thus, the light receiving electrode 120 is an H-shaped electrode when viewed in plan. The detection electrode 121 and the detection electrode 122 preferably have the same shape. With the detection electrode 121 and the detection electrode 122 having the same shape, infrared detection accuracy is improved.

The light receiving electrode 110 and the light receiving electrode 120 are arranged side by side in the second direction. The light receiving electrode 110 and the light receiving electrode 120 are spaced from each other.

The blackened film 131 is arranged over an entire surface of the detection electrode 111 in the light receiving electrode 110. The blackened film 132 is arranged over an entire surface of the detection electrode 112 in the light receiving electrode 110. In other words, the blackened films 131 and 132 are arranged only on the surfaces of the detection electrodes 111 and 112 in the light receiving electrode 110. The blackened films 131 and 132 correspond to "infrared absorption films" in the present invention.

With the above-described constitution, infrared reception sensitivity of the light receiving electrode 110 becomes higher than that of the light receiving electrode 120. Each of the blackened films 131 and 132 corresponds to a "light-sensitivity adjustment member" in the present invention.

Thus, detection sensitivity for infrared light detected by the light receiving electrode 110 becomes higher than that for infrared light detected by the light receiving electrode 120. Accordingly, infrared detection sensitivity in a first infrared-detection target region (corresponding to a "first region" in the present invention) assigned to the light receiving electrode 110 is different from that in a second infrared-detection target region (corresponding to a "secondregion" in the present invention) assigned to the light receiving electrode 120. The infrared detection element 10 constituted as described above enables detection of infrared light to be performed for plural regions providing different detection sensitivities with a simple constitution. As a result, a size of the infrared detection element 10 can be reduced.

The connection electrodes 141 and 142 are formed on a rear surface of the pyroelectric body 101. The connection electrode 141 is opposed to the detection electrode 111 in the light receiving electrode 110 and the detection electrode 121 in the light receiving electrode 120 with the pyroelectric body 101 interposed therebetween. The connection electrode 142 is opposed to the detection electrode 112 in the light receiving electrode 110 and the detection electrode 122 in the light receiving electrode 120 with the pyroelectric body 101 interposed therebetween.

The infrared detection element 10 constituted as described above is used in an infrared detection device illustrated in Fig. 2. Fig. 2 is a circuit diagram of the infrared detection device according to the first embodiment of the present invention.

As illustrated in Fig. 2, the infrared detection device 30 includes an infrared detection element 10, an impedance conversion element 21, and a determination unit 31. The infrared detection element 10 and the impedance conversion element 21 constitute an infrared sensor 20. The infrared sensor 20 has a ground terminal PG, a drive-voltage input terminal PD, and an output terminal PO.

The infrared detection element 10 has the above-described constitution illustrated in Fig. 1. The infrared detection element 10 includes a first element E1 including the light receiving electrode 110 and the pyroelectric body 101, and a second element E2 including the light receiving electrode 120 and the pyroelectric body 101. The first element E1 and the second element E2 are connected in parallel by the connection electrode 141 and the connection electrode 142.

The infrared detection element 10 is connected to the impedance conversion element 21 through the connection electrode 141. The connection electrode 141 corresponds to a "connection portion" in the present invention. The infrared detection element 10 is connected to the ground terminal PG through the connection electrode 142. The ground terminal PG is grounded.

The impedance conversion element 21 is constituted by an n-type FET, for example. A gate G of the n-type FET is connected to the connection electrode 141. A drain of the n-type FET is connected to the drive-voltage input terminal PD. A source of the n-type FET is connected to the output terminal PO.

The determination unit 31 is constituted by a microcomputer, etc. The determination unit 31 is connected to the output terminal PO of the infrared sensor 20.

When the infrared detection element 10 detects infrared light, a voltage depending on generated electric charges is applied to the gate of the n-type FET constituting the impedance conversion element 21. A drive voltage VDD is applied to the impedance conversion element 21 via the drive-voltage input terminal PD. The impedance conversion element 21 outputs a source voltage having a magnitude depending on the gate voltage. This source voltage signal corresponds to a "detection signal" in the present invention.

The determination unit 31 executes detection of the infrared light on the basis of the magnitude of the source voltage signal.

In the infrared detection element 10, infrared detection sensitivity is different between the first element E1 including the light receiving electrode 110 and the second element E2 including the light receiving electrode 120. Accordingly, electric charges generated in detecting the infrared light are different between the first infrared-detection target region, i.e., a detection target of the first element E1, and the second infrared-detection target region, i.e., a detection target of the second element E2. Hence the magnitude (amplitude) of the detection signal output from the impedance conversion element 21 is also different therebetween.

By detecting the magnitude of the detection signal, the determination unit 31 can easily determine in which one of the first infrared-detection target region and the second infrared-detection target region the infrared light has been detected.

Furthermore, the determination unit 31 previously stores a threshold for the magnitude of the detection signal, and compares the detection signal with the threshold. Depending on a comparison result, if the magnitude of the detection signal is not smaller than the threshold, the determination unit 31 determines that the infrared light has been detected. Thus, the infrared detection device 30 can realize the detection of the infrared light in a manner of restricting (or exclusively aiming at) the detection target.

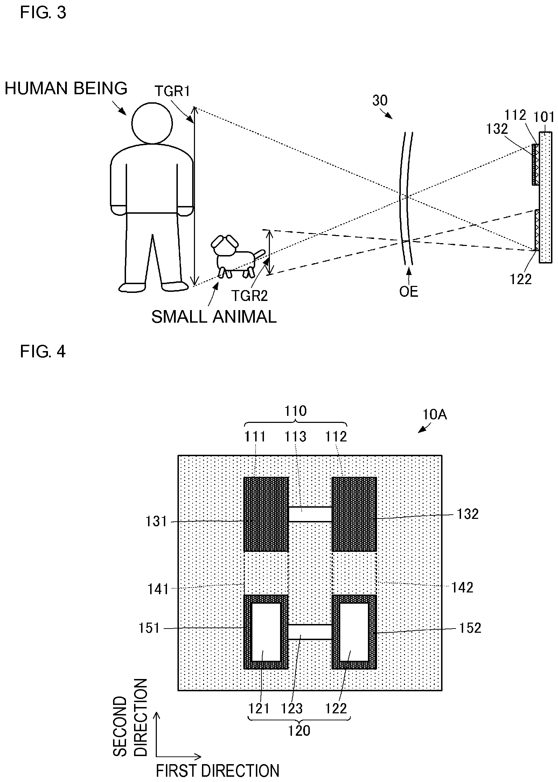

Fig. 3 illustrates an application example of the infrared detection device according to the present invention. In the example of Fig. 3, the infrared detection device 30 includes an optical element OE. In the infrared detection device, the first infrared-detection target region TGR1 is set as a region targeting a human being, but not targeting a small animal, such as a dog, or a moving low-height heat source body. The second infrared-detection target region TGR2 is set to mainly target the small animal, such as the dog, or the moving low-height heat source body, and to allow part of the human being to be included therein.

With the above-described setting, in the infrared detection element 10 and the infrared detection device 30, the detection sensitivity can be increased for the region targeting the human being, but not targeting the small animal, and can be reduced for the region targeting the small animal. Accordingly, the infrared detection element 10 and the infrared detection device 30, each reliably detecting the human being and reliably not detecting the small animal, can be realized. Moreover, the infrared detection device 30 is not required to include the detection circuit for each element, i.e., for each detection-target region. As a result, the infrared detection device 30 can be realized in a small size with a simple constitution.

An infrared detection element according to a second embodiment of the present invention will be described below with reference to the drawing. Fig. 4 is a plan view illustrating a constitution of the infrared detection element according to the second embodiment of the present invention.

As illustrated in Fig. 4, the infrared detection element 10A according to the second embodiment is different from the infrared detection element 10 according to the first embodiment in adding blackened films 151 and 152. Other constituent elements of the infrared detection element 10A are similar to those of the infrared detection element 10, and description of the same constituent elements is omitted.

The infrared detection element 10A includes the blackened films 151 and 152. Each of the blackened films 151 and 152 corresponds to the "light-sensitivity adjustment member" in the present invention. The blackened film 151 is formed on a surface of the detection electrode 121 in the light receiving electrode 120. The blackened film 151 covers part of the detection electrode 121. More specifically, the blackened film 151 is formed along sides of the detection electrode 121. The blackened film 151 is not formed in a central region of the detection electrode 121. The blackened film 152 is formed on a surface of the detection electrode 122 in the light receiving electrode 120. The blackened film 152 covers part of the detection electrode 122. More specifically, the blackened film 152 is formed along sides of the detection electrode 122. The blackened film 152 is not formed in a central region of the detection electrode 122.

With the above-described constitution, a coverage of the blackened films 131 and 132 with respect to the surface of the light receiving electrode 110 can be made different from that of the blackened films 151 and 152 with respect to the surface of the light receiving electrode 120. Accordingly, the light sensitivity of the light receiving electrode 110 can be made different from that of the light receiving electrode 120. Furthermore, with the above-described constitution, the sensitivity difference between the light sensitivity of the light receiving electrode 110 and the light sensitivity of the light receiving electrode 120 can be adjusted by adjusting the coverage of the blackened films 151 and 152 with respect to the surface of the light receiving electrode 120.

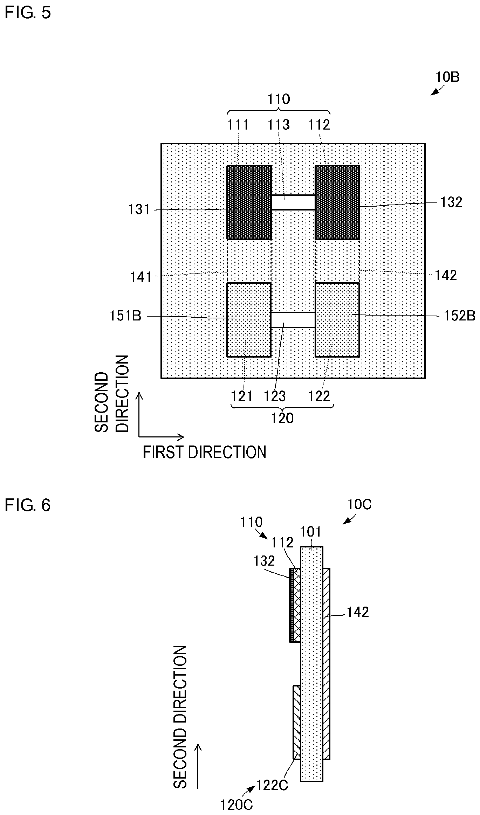

An infrared detection element according to a third embodiment of the present invention will be described below with reference to the drawing. Fig. 5 is a plan view illustrating a constitution of the infrared detection element according to the third embodiment of the present invention.

As illustrated in Fig. 5, the infrared detection element 10B according to the third embodiment is different from the infrared detection element 10 according to the first embodiment in adding blackened films 151B and 152B. Other constituent elements of the infrared detection element 10B are similar to those of the infrared detection element 10, and description of the same constituent elements is omitted.

The infrared detection element 10B includes the blackened films 151B and 152B. Each of the blackened films 151B and 152B corresponds to the "light-sensitivity adjustment member" in the present invention. The blackened film 151B is formed over the entire surface of the detection electrode 121 in the light receiving electrode 120. The blackened film 152B is formed over the entire surface of the detection electrode 122 in the light receiving electrode 120.

An infrared absorbance of the blackened films 151B and 152B is lower than that of the blackened films 131 and 132.

Also with the above-described constitution, the light sensitivity of the light receiving electrode 110 can be made different from that of the light receiving electrode 120.

Furthermore, with the above-described constitution, the difference between the light sensitivity of the light receiving electrode 110 and the light sensitivity of the light receiving electrode 120 can be adjusted by adjusting the difference between the infrared absorbance of the blackened films 131 and 132 and the infrared absorbance of the blackened films 151B and 152B.

An infrared detection element according to a fourth embodiment of the present invention will be described below with reference to the drawing. Fig. 6 is a side sectional view illustrating a constitution of the infrared detection element according to the fourth embodiment of the present invention.

As illustrated in Fig. 6, the infrared detection element 10C according to the fourth embodiment is different from the infrared detection element 10 according to the first embodiment in including a light receiving electrode 120C instead of the light receiving electrode 120. Other constituent elements of the infrared detection element 10C are similar to those of the infrared detection element 10, and description of the same constituent elements is omitted.

The infrared detection element 10C includes the light receiving electrode 120C. The light receiving electrode 120C has the same shape as the light receiving electrode 120 in the first embodiment. An infrared absorbance of the light receiving electrode 120C (i.e., the electrode including the detection electrode 122C in Fig. 6) is lower than that of the light receiving electrode 110 (i.e., the electrode including the detection electrode 112 in Fig. 6).

Also with the above-described constitution, the light sensitivity of the light receiving electrode 110 can be made different from that of the light receiving electrode 120C. Furthermore, with the above-described constitution of the infrared detection element 10C, the difference in infrared detection sensitivity between the first element E1 and the second element E2 can be further increased due to the synergetic effect of both the difference in light sensitivity between the light receiving electrode 110 and the light receiving electrode 120, which is caused by the presence of the blackened films 131 and 132, and the difference in light sensitivity between the light receiving electrode 110 and the light receiving electrode 120C, which is caused by materials of those electrodes.

Moreover, with the above-described constitution, the sensitivity difference between the light sensitivity of the light receiving electrode 110 and the light sensitivity of the light receiving electrode 120C can be adjusted by adjusting the difference between the infrared absorbance of the light receiving electrode 110 and the infrared absorbance of the light receiving electrode 120C.

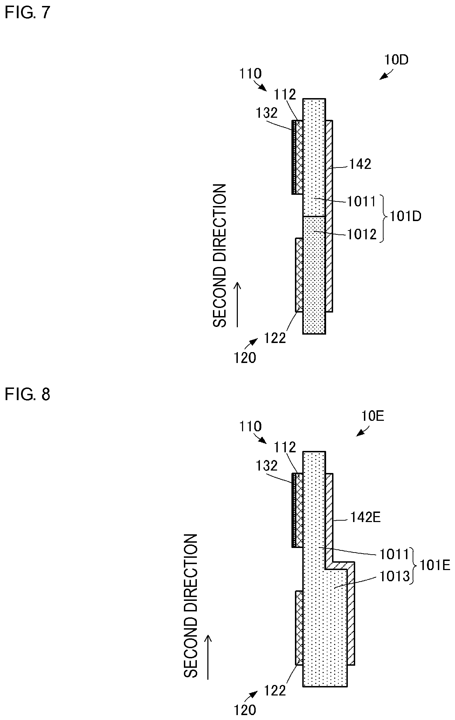

An infrared detection element according to a fifth embodiment of the present invention will be described below with reference to the drawing. Fig. 7 is a side sectional view illustrating a constitution of the infrared detection element according to the fifth embodiment of the present invention.

As illustrated in Fig. 7, the infrared detection element 10D according to the fifth embodiment is different from the infrared detection element 10 according to the first embodiment in constitution of a pyroelectric body 101D. Other constituent elements of the infrared detection element 10D are similar to those of the infrared detection element 10 according to the first embodiment, and description of the same constituent elements is omitted.

The infrared detection element 10D includes the pyroelectric body 101D. The pyroelectric body 101D includes a first region 1011 and a second region 1012. The first region 1011 and the second region 1012 are arrayed side by side in the second direction. A polarizability of the first region 1011 is higher than that of the second region 1012. The light receiving electrode 110 is formed on a surface of the first region 1011. The light receiving electrode 120 is formed on a surface of the second region 1012.

With the above-described constitution, the difference in infrared detection sensitivity between the first element E1 and the second element E2 can be increased. Moreover, with the constitution of the infrared detection element 10D, the difference in infrared detection sensitivity between the first element E1 and the second element E2 can be further increased due to the synergetic effect of both the difference in light sensitivity between the light receiving electrode 110 and the light receiving electrode 120, which is caused by the presence of the blackened films 131 and 132, and the difference in polarizability between the first region 1011 and the second region 1012 of the pyroelectric body 101D.

An infrared detection element according to a sixth embodiment of the present invention will be described below with reference to the drawing. Fig. 8 is a side sectional view illustrating a constitution of the infrared detection element according to the sixth embodiment of the present invention.

As illustrated in Fig. 8, the infrared detection element 10E according to the sixth embodiment is different from the infrared detection element 10 according to the first embodiment in constitution of a pyroelectric body 101E. Other constituent elements of the infrared detection element 10E are similar to those of the infrared detection element 10 according to the first embodiment, and description of the same constituent elements is omitted.

The infrared detection element 10E includes the pyroelectric body 101E. The pyroelectric body 101E includes a first region 1011 and a second region 1013. The first region 1011 and the second region 1013 are arrayed side by side in the second direction. A thickness of the first region 1011 is smaller than that of the second region 1013. The light receiving electrode 110 is formed on a surface of the first region 1011. The light receiving electrode 120 is formed on a surface of the second region 1013. Because of having the above-described constitution, a capacitance formed in the first region 1011 between the light receiving electrode 110 and each of the connection electrodes 141 and 142 is greater than that formed in the second region 1013 between the light receiving electrode 120 and each of the connection electrodes 141 and 142.

With the above-described constitution, the difference in infrared detection sensitivity between the first element E1 and the second element E2 can be increased. Moreover, with the constitution of the infrared detection element 10E, the difference in infrared detection sensitivity between the first element E1 and the second element E2 can be further increased due to the synergetic effect of both the difference in light sensitivity between the light receiving electrode 110 and the light receiving electrode 120, which is caused by the presence of the blackened films 131 and 132, and the difference in thickness between the first region 1011 and the second region 1013 of the pyroelectric body 101E

The constitutions of the above-described embodiments can be combined with each other as appropriate. Various advantageous effects can be obtained depending on the combinations of the constitutions.

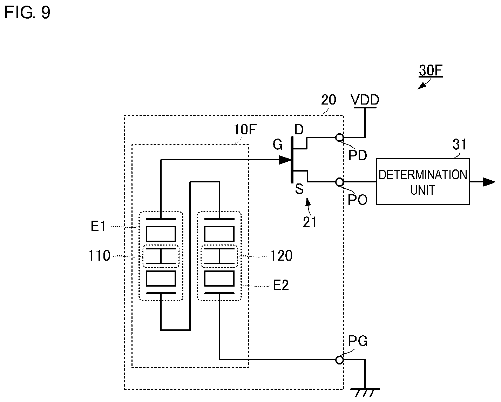

The first embodiment illustrates the constitution in which the first element E1 and the second element E2 are connected in parallel. However, the constitution may be modified as illustrated in Fig. 9. Fig. 9 is a circuit diagram of an infrared detection device in another form according to an embodiment of the present invention.

As illustrated in Fig. 9, in an infrared detection element 10F, the first element E1 and the second element E2 are connected in series. In an infrared detection device 30F, the serial circuit is connected between the impedance conversion element 21 and the ground terminal PG.

The above-described constitution can also provide similar advantageous to those obtained with the infrared detection element 10 and the infrared detection device 30, illustrated in Fig. 2, according to the first embodiment.

While the above description has been made in connection with the case in which the detection electrode has the rectangular shape, the detection electrode may have a polygonal or circular shape.

### Reference Signs List

10, 10A, 10B, 10C, 10D, 10E, 10F: infrared detection element
20: infrared sensor
21: impedance conversion element
30, 30F: infrared detection device
31: determination unit
101, 101D, 101E: pyroelectric body
110: light receiving electrode
111, 112: detection electrode
113, 123: wiring electrode
120, 120C: light receiving electrode
121, 122, 122C: detection electrode
131, 132, 151, 151B, 152, 152B: blackened film
141, 142: connection electrode
1011: first region
1012, 1013: second region
E1: first element
E2: second element
OE: Optical element
PD: drive-voltage input terminal
PG: ground terminal
PO: output terminal
TGR1: first infrared-detection target region
TGR2: second infrared-detection target region
VDD: drive voltage

## Claims

1. An infrared detection device (30) comprising;
an infrared detection element (10), which comprises:
a pyroelectric body (101);
a first light receiving electrode (110) formed on a surface of the pyroelectric body (101);
a second light receiving electrode (120) formed on a surface of the pyroelectric body (101); and
a light-sensitivity adjustment member (131, 132, 151, 152) comprising an infrared absorption film arranged on a surface of at least the first light receiving electrode (110), and configured to make infrared reception sensitivity of the first light receiving electrode (110) higher than that of the second light receiving electrode (120); wherein the infrared detection device (30) further comprises
an optical element (OE);
**characterised in that** the optical element is configured to direct light from a first infrared- detection target region (TGR1), set as a region targeting a first detection target,
to the first light receiving electrode (110), wherein the first electrode (110) is configured to receive light from the first infrared-detection target region (TGR1), and to direct light from a second infrared-detection target region (TGR2), set as a region targeting mainly a second detection target and part of the first detection target, to the second light receiving electrode (120) wherein the second light receiving electrode (120) is configured to receive light from the second infrared-detection target region (TGR2); and
wherein the detection sensitivity is increased for the first infrared-detection target region (TGR1) and is reduced for the second infrared-detection target region (TGR2), such that the first detection target in the first infrared-detection target region is distinguished from the second detection target in the second infrared-detection target region.

2. The infrared detection element (10) according to claim 1, wherein the light-sensitivity adjustment member (131, 132, 151, 152) is an infrared absorption film arranged only on a surface of the first light receiving electrode (110).

3. The infrared detection element (10) according to claim 1, wherein the light-sensitivity adjustment member (131, 132, 151, 152) is a first infrared absorption film arranged on a surface of the first light receiving electrode (110), and a second infrared absorption film arranged on a surface of the second light receiving electrode (120), and wherein
the first infrared absorption film has a higher infrared absorbance than the second infrared absorption film.

4. The infrared detection element (10) according to claim 3, wherein a coverage of the first infrared absorption film with respect to the surface of the first light receiving electrode (110) is higher than a coverage of the second infrared absorption film with respect to the surface of the second light receiving electrode (120).

5. The infrared detection element (10) according to any one of claim 1 to 4, wherein the first light receiving electrode (110) has a higher infrared absorbance than the second light receiving electrode (120).

6. The infrared detection element (10) according to any one of claims 1 to 5, wherein a polarizability of the pyroelectric body (101) is different between a first region (1011) in which the first light receiving electrode (110) is formed on the surface of the pyroelectric body (101) and a second region (1012, 10103) in which the second light receiving electrode (120) is formed on the surface of the pyroelectric body (101), and
the first region (1011) has a higher polarizability than the second region (1012, 1013).

7. The infrared detection element (10) according to any one of claims 1 to 6, wherein a thickness of the pyroelectric body (101) is different between a first region (1011) in which the first light receiving electrode (110) is formed on the surface of the pyroelectric body (101) and a second region (1012, 1013) in which the second light receiving electrode (120) is formed on the surface of the pyroelectric body (101), and
the pyroelectric body (101) in the first region (1011) has a smaller thickness than the pyroelectric body (101) in the second region (1012, 1013).

8. The infrared detection device according to any one of claims 1 to 7, the infrared detection device comprising:
a first element (E1) including the first light receiving electrode (110) and the pyroelectric body (101);
a second element (E2) including the second light receiving electrode (120) and the pyroelectric body (101);
a connection portion which interconnects the first element (E1) and the second element (E2);
an impedance conversion element configured to generate detection signals from electric charges in the first element (E1) and the second element (E2) through the connection portion; and
a determination unit (31) configured to determine detection of infrared light on basis of the detection signals.

## Patentansprüche

1. Infrarot-Erkennungsvorrichtung (30), die aufweist:
ein Infrarot-Erkennungselement (10), das aufweist:
einen pyroelektrischen Körper (101);
eine erste Lichtaufnahmeelektrode (110), die an einer Oberfläche des pyroelektrischen Körpers (101) gebildet ist;
eine zweite Lichtaufnahmeelektrode (120), die an einer Oberfläche des pyroelektrischen Körpers (101) gebildet ist; und
ein Element zum Einstellen der Lichtempfindlichkeit (131, 132, 151, 152), das eine Infrarot-Absorptionsfolie aufweist, die auf einer Oberfläche von mindestens der ersten Lichtaufnahmeelektrode (110) angeordnet ist, und zum Bewirken, dass die Infrarot-Aufnahmeempfindlichkeit der ersten Lichtaufnahmeelektrode (110) höher ist als die der zweiten Lichtaufnahmeelektrode (120), konfiguriert ist; wobei die Infrarot-Erkennungsvorrichtung (30) ferner aufweist:
ein optisches Element (OE);
**dadurch gekennzeichnet, dass** das optische Element zum Leiten von Licht von einer ersten Infrarot-Erkennungszielregion (TGR1), die als eine auf ein erstes Erkennungsziel abzielende Region eingestellt ist, auf die erste Lichtaufnahmeelektrode konfiguriert ist,
wobei die erste Elektrode (110) zum Aufnehmen von Licht von der ersten Infrarot-Erkennungszielregion (TGR1) und zum Leiten von Licht von einer zweiten Infrarot-Erkennungsregion (TGR2), die als eine hauptsächlich auf ein zweites Erkennungsziel und Teil des ersten Erkennungsziels abzielende Region eingestellt ist, zu der zweiten Lichtaufnahmeelektrode (120) konfiguriert ist, wobei die zweite Lichtaufnahmeelektrode (120) zum Aufnehmen von Licht von der zweiten Infrarot-Erkennungszielregion (TGR2) konfiguriert ist; und
wobei die Erkennungsempfindlichkeit für die erste Infrarot-Erkennungszielregion (TGR1) erhöht ist und für die zweite Infrarot-Erkennungszielregion (TGR2) verringert ist, so dass das erste Erkennungsziel in der ersten Infrarot-Erkennungszielregion von dem zweiten Erkennungsziel in der zweiten Infrarot-Erkennungszielregion unterschieden wird.

2. Infrarot-Erkennungselement (10) nach Anspruch 1, wobei das Element zum Einstellen der Lichtempfindlichkeit (131, 132, 151, 152) eine Infrarot-Absorptionsfolie ist, die nur auf einer Oberfläche der ersten Lichtaufnahmeelektrode (110) angeordnet ist.

3. Infrarot-Erkennungselement (10) nach Anspruch 1, wobei das Element zum Einstellen der Lichtempfindlichkeit (131, 132, 151, 152) eine erste Infrarot-Absorptionsfolie, die auf einer Oberfläche der ersten Lichtaufnahmeelektrode (110) angeordnet ist, und eine zweite Infrarot-Absorptionsfolie, die auf einer Oberfläche der zweiten Lichtaufnahmeelektrode (120) angeordnet ist, ist und wobei
die erste Infrarot-Absorptionsfolie eine höhere Infrarot-Absorbanz als die zweite Infrarot-Absorptionsfolie aufweist.

4. Infrarot-Erkennungselement (10) nach Anspruch 3, wobei die Bedeckung der ersten Infrarot-Absorptionsfolie in Bezug auf die Oberfläche der ersten Lichtaufnahmeelektrode (110) höher ist als die Bedeckung der zweiten Infrarot-Absorptionsfolie in Bezug auf die Oberfläche der zweiten Lichtaufnahmeelektrode (120).

5. Infrarot-Erkennungselement (10) nach einem der Ansprüche 1 bis 4, wobei die erste Lichtaufnahmeelektrode (110) eine höhere Infrarot-Absorbanz als die zweite Lichtaufnahmeelektrode (120) aufweist.

6. Infrarot-Erkennungselement (10) nach einem der Ansprüche 1 bis 5, wobei eine Polarisierbarkeit des pyroelektrischen Körpers (101) zwischen einer ersten Region (1011), in der die erste Lichtaufnahmeelektrode (110) auf der Oberfläche des pyroelektrischen Körpers (101) gebildet ist, und einer zweiten Region (1012, 10103), in der die zweite Lichtaufnahmeelektrode (120) auf der Oberfläche des pyroelektrischen Körpers (101) gebildet ist, unterschiedlich ist und
die erste Region (1011) eine höhere Polarisierbarkeit hat als die zweite Region (1012, 1013).

7. Infrarot-Erkennungselement (10) nach einem der Ansprüche 1 bis 6, wobei eine Dicke des pyroelektrischen Körpers (101) zwischen einer ersten Region (1011), in der die erste Lichtaufnahmeelektrode (110) auf der Oberfläche des pyroelektrischen Körpers (101) gebildet ist, und einer zweiten Region (1012, 1013), in der die zweite Lichtaufnahmeelektrode (120) auf der Oberfläche des pyroelektrischen Körpers (101) gebildet ist, verschieden ist und
der pyroelektrische Körper (101) in der ersten Region (1011) eine geringere Dicke aufweist als der pyroelektrische Körper (101) in der zweiten Region (1012, 1013).

8. Infrarot-Erkennungsvorrichtung nach einem der Ansprüche 1 bis 7, wobei die Infrarot-Erkennungsvorrichtung aufweist:
ein erstes Element (E1), das die erste Lichtaufnahmeelektrode (110) und den pyroelektrischen Körper (101) umfasst;
ein zweites Element (E2), das die zweite Lichtaufnahmeelektrode (120) und den pyroelektrischen Körper (101) umfasst;
einen Verbindungsabschnitt, der das erste Element (El) und das zweite Element (E2) miteinander verbindet;
ein Impedanzwandlerelement, das zum Erzeugen von Erkennungssignalen aus elektrischen Ladungen in dem ersten Element (El) und dem zweiten Element (E2) durch den Verbindungsabschnitt konfiguriert ist; und
eine Bestimmungseinheit (31), die zum Bestimmen der Detektion von Infrarotlicht auf Basis der Erkennungssignale konfiguriert ist.

## Revendications

1. Dispositif de détection infrarouge (30) comprenant ;
un élément de détection infrarouge (10), qui comprend :
un corps pyroélectrique (101) ;
une première électrode réceptrice de lumière (110) formée sur une surface du corps pyroélectrique (101) ;
une deuxième électrode réceptrice de lumière (120) formée sur une surface du corps pyroélectrique (101) ; et
un membre d'ajustement de sensibilité à la lumière (131, 132, 151, 152) comprenant un film d'absorption infrarouge arrangé sur une surface d'au moins la première électrode réceptrice de lumière (110), et configuré pour rendre une sensibilité de réception infrarouge de la première électrode réceptrice de lumière (110) plus élevée que celle de la deuxième électrode réceptrice de lumière (120) ; dans lequel le dispositif de détection infrarouge (30) comprend en outre :
un élément optique (OE) ;
**caractérisé en ce que** l'élément optique est configuré pour diriger la lumière d'une première région cible de détection infrarouge (TGR1), réglée comme une région ciblant une première cible de détection, vers la première électrode réceptrice de lumière (110),
dans lequel la première électrode (110) est configurée pour recevoir la lumière de la première région cible de détection infrarouge (TGR1), et diriger la lumière d'une deuxième région cible de détection infrarouge (TGR2), réglée comme une région ciblant essentiellement une deuxième cible de détection et une partie de la première cible de détection, vers la deuxième électrode réceptrice de lumière (120), dans lequel la deuxième électrode réceptrice de lumière (120) est configurée pour recevoir la lumière de la deuxième région cible de détection infrarouge (TGR2) ; et
dans lequel la sensibilité de détection est augmentée pour la première région cible de détection infrarouge (TGR1) et est réduite pour la deuxième région cible de détection infrarouge (TGR2), de sorte la première cible de détection dans la première région cible de détection infrarouge est différenciée de la deuxième cible de détection dans la deuxième région cible de détection infrarouge.

2. Elément de détection infrarouge (10) selon la revendication 1, dans lequel le membre d'ajustement de sensibilité à la lumière (131, 132, 151, 152) est un film d'absorption infrarouge arrangé seulement sur une surface de la première électrode réceptrice de lumière (110).

3. Elément de détection infrarouge (10) selon la revendication 1, dans lequel le membre d'ajustement de sensibilité à la lumière (131, 132, 151, 152) est un premier film d'absorption infrarouge arrangé sur une surface de la première électrode réceptrice de lumière (110), et un deuxième film d'absorption infrarouge arrangé sur une surface de la deuxième électrode réceptrice de lumière (120), et dans lequel le premier film d'absorption infrarouge a une absorbance infrarouge plus élevée que le deuxième film d'absorption infrarouge.

4. Elément de détection infrarouge (10) selon la revendication 3, dans lequel une couverture du premier film d'absorption infrarouge par rapport à la surface de la première électrode réceptrice de lumière (110) est plus grande qu'une couverture du deuxième film d'absorption infrarouge par rapport à la surface de la deuxième électrode réceptrice de lumière (120).

5. Elément de détection infrarouge (10) selon l'une quelconque des revendications 1 à 4, dans lequel la première électrode réceptrice de lumière (110) a une absorbance infrarouge plus élevée que la deuxième électrode réceptrice infrarouge (120).

6. Elément de détection infrarouge (10) selon l'une quelconque des revendications 1 à 5, dans lequel une polarisabilité du corps pyroélectrique (101) est différente entre une première région (1011) dans laquelle la première électrode réceptrice de lumière (110) est formée sur la surface du corps pyroélectrique (101) et une deuxième région (1012, 10103) dans laquelle la deuxième électrode réceptrice de lumière (120) est formée sur la surface du corps pyroélectrique (101), et
la première région (1011) a une polarisabilité plus élevée que la deuxième région (1012, 1013).

7. Elément de détection infrarouge (10) selon l'une quelconque des revendications 1 à 6, dans lequel une épaisseur du corps pyroélectrique (101) est différente entre une première région (1011) dans laquelle la première électrode réceptrice de lumière (110) est formée sur la surface du corps pyroélectrique (101) et une deuxième région (1012, 1013) dans laquelle la deuxième électrode réceptrice de lumière (120) est formée sur la surface du corps pyroélectrique (101), et
le corps pyroélectrique (101) dans la première région (1011) a une plus faible épaisseur que le corps pyroélectrique (101) dans la deuxième région (1012, 1013).

8. Dispositif de détection infrarouge selon l'une quelconque des revendications 1 à 7, le dispositif de détection infrarouge comprenant :
un premier élément (E1) comprenant la première électrode réceptrice de lumière (110) et le corps pyroélectrique (101) ;
un deuxième élément (E2) comprenant la deuxième électrode réceptrice de lumière (120) et le corps pyroélectrique (101) ;
une partie de connexion qui interconnecte le premier élément (E1) et le deuxième élément (E2) ;
un élément de conversion d'impédance configuré pour générer des signaux de détection à partir de charges électriques dans le premier élément (E1) et le deuxième élément (E2) via la partie de connexion ; et
une unité de détermination (31) configurée pour déterminer la détection de lumière infrarouge sur la base des signaux de détection.
